# EUROPEAN PATENT SPECIFICATION

(11) **EP 3 405 594 B1**
(45) Date of publication and mention of the grant of the patent: **14.04.2021**
(21) Application number: 17705955.7
(22) Date of filing: 20.01.2017
(51) Int. Cl.: C23C 14/00

(54) **PROCEDURE FOR THE COATING OF PROFILED ELEMENTS MADE OF PLASTIC MATERIAL FOR DOOR AND WINDOW FRAMES**
VERFAHREN ZUR BESCHICHTUNG VON PROFILELEMENTEN AUS KUNSTSTOFFMATERIAL FÜR TÜR- UND FENSTERRAHMEN
PROCÉDÉ DE REVÊTEMENT D'ÉLÉMENTS PROFILÉS EN MATIÈRE PLASTIQUE POUR CADRES DE PORTE ET DE FENÊTRE

(30) Priority: 22.01.2016 IT UB20160287
(43) Date of publication of application: 28.11.2018
(73) Proprietor: Graf Synergy S.r.l., 41015 Nonantola (MO) (IT)
(72) Inventor: VACCARI, Andrea, 41015 Nonantola (MO) (IT)
(74) Representative: Luppi, Emanuele
(86) International application number: PCT/IB2017/050311
(87) International publication number: WO 2017/125891

(56) References cited:
- JP-A- H10 299 342
- US-A1- 2013 244 052

## Description

### Technical Field

The present invention relates to a procedure for the coating of profiled elements made of plastic material for door and window frames.

### Background Art

In many industrial sectors the need is particularly felt to renew the manufactured articles and find new ones in order to better distinguish these from those of the competition.

This need is particularly felt in the industry dealing with the manufacture of frames, such as doors and windows made of plastic material, in particular PVC. These frames consist of a series of profiled elements made of plastic which are sealed to each other by the melting of respective head surfaces in order to achieve a frame structure.

Compared to the door and window frames made of materials such as wood and aluminum, those made of plastic are commonly considered less appealing from an aesthetic point of view.

In the context of the industry of doors and windows made of plastic material, therefore, the need is particularly felt to improve the aesthetic appearance of the profiled elements in order to get original products with new forms that have innovative features aimed at improving the aesthetic perception of the product and being more appealing for customers.

In this regard, it is known to coat the door and window frames made of plastic material by means of coloring layers which have the main drawback of being not so long-lasting and easily damageable by human actions or by atmospheric agents, thus requiring maintenance operations for restoring the original aesthetic appearance.

To this drawback are related the maintenance costs borne by the buyers thus jeopardizing the degree of attractiveness of such products to customers. Document JP H10 299342 A describes a process of the known type for the coating of a profiled elements by vapor-deposition of aluminium on a building element.

Document US 2013/244052 A1 describes a process of the known type for the coating of a profiled elements which includes a sputter welding of a primary metallic layer onto a surface of a substrate of an architectural component.

### Description of the Invention

The main aim of the present invention is to provide a procedure for the coating of profiled elements made of plastic material for door and window frames which allows to meet the above mentioned need and which allows, in a practical, easy and functional manner, to manufacture an innovative, original, and durable article, as well as of fine workmanship.

One object of the present invention is to provide a procedure for the coating of profiled elements made of plastic material for door and window frames which allows to make the profiled elements themselves as much as possible resistant to human actions and/or to atmospheric agents in order to ensure a longer life and reduction in any maintenance operations for restoring the original aesthetic appearance.

Another object of the present invention is to provide a procedure for the coating of profiled elements made of plastic material for door and window frames which allows overcoming the mentioned drawbacks of the prior art within the ambit of a simple, rational, easy, effective to use and affordable solution.

The above mentioned objects are achieved by the present procedure for the coating of profiled elements made of plastic material for door and window frames having the characteristics of claim 1.

### Brief Description of the Drawings

Other characteristics and advantages of the present invention will become better evident from the description of a preferred, but not exclusive, embodiment of a procedure for the coating of profiled elements made of plastic material for door and window frames, illustrated by way of an indicative, but non-limiting example in the accompanying drawings, wherein:

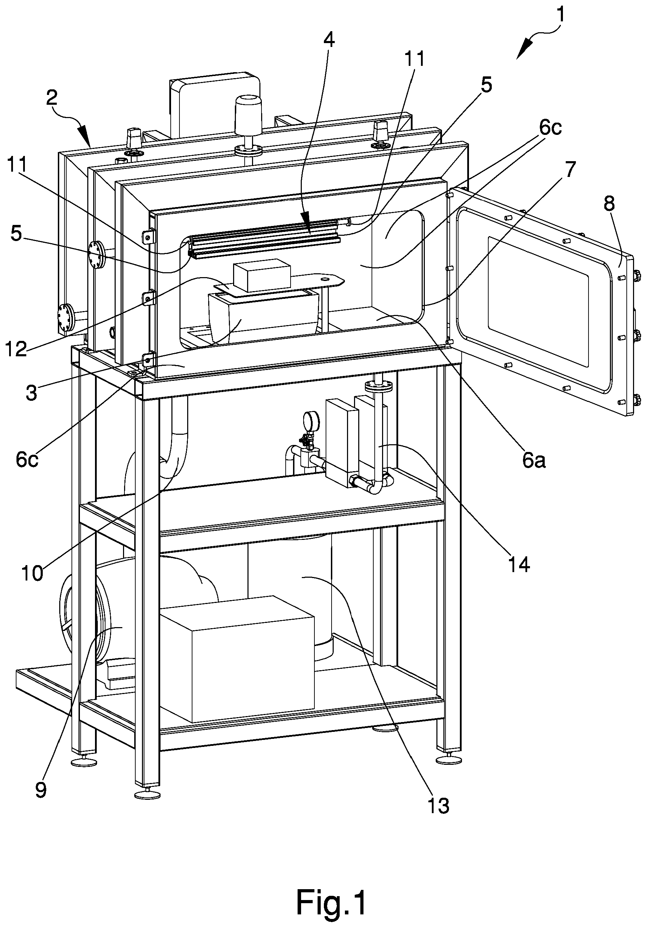

Figure 1 is an axonometric view of vacuum machinery employed in the procedure according to the invention;
Figures from 2 to 8 schematically illustrate the procedure according to the invention.

### Embodiments of the Invention

The procedure for the coating of profiled elements made of plastic material for door and window frames comprises one step of supply of at least a vacuum machinery 1 comprising a vacuum cabin 2 having a device for physical vapor deposition 3 adapted to the coating of at least one profiled element 4 made of plastic material to be coated for the manufacture of door and window frames.

The profiled element 4 comprises a pair of head surfaces 5, opposite to each other and defining the ending parts of the profiled element itself.

More in detail, the profiled element 4 extends along a longitudinal direction and the ending parts of the profiled element itself match the head surfaces 5.

The vacuum cabin 2 has a plurality of walls 6a, 6b, 6c, of which a bottom wall 6a, a top wall 6b and a series of side walls 6c.

The side walls 6c are shaped and arranged so as to define an opening 7 through which it is possible to access the inside of the vacuum cabin 2 by means of an access door 8 arranged at the opening 7 and sealingly closable.

In the particular embodiment shown in the figures, the vacuum cabin 2 is sized and configured to allow the entry and the housing of a profiled element 4.

Alternative embodiments cannot however be ruled out in which the vacuum cabin 2 is sized according to the intended use, i.e. depending on whether it has to house a single profiled element 4 or a plurality of profiled elements 4 assembled together to make at least one frame of doors and windows.

In this case, the vacuum cabin 2 can comprise a plurality of devices for physical vapor deposition 3 which are arranged, e.g., in the proximity of each profiled element 4, in which each of the devices for physical vapor deposition 3 is adapted to the coating of a respective profiled element 4.

With the vacuum cabin 2 are associated vacuum pumping means 9 adapted to generate vacuum in the vacuum cabin itself.

The vacuum pumping means 9 comprise a primary vacuum pump fixed onto the vacuum cabin 2 and placed in fluidic connection with the inside of the vacuum cabin itself to obtain special high vacuum conditions therein.

Advantageously, the pumping means 9 comprise a secondary vacuum pump that is connected and interlocked to the vacuum cabin 2 through at least one connection pipe 10.

The procedure comprises one step of insertion of the profiled element 4 within the vacuum cabin 2.

For this purpose, the vacuum cabin 2 comprises a pair of supporting elements 11 which extend in the vertical direction and are adapted to support the profiled element 4 after being introduced in the vacuum cabin 2.

More in detail, the supporting elements 11 have first ending parts, associated with the top wall 6b, and second ending parts, opposite to the first ending parts, each arranged on the respective head surface 5 and adapted to maintain in fixed position the profiled element 4 in a working position.

In other words, the profiled element 4, fixed by means of the second ending parts, is arranged substantially horizontal with respect to the ground in the working position.

Alternative embodiments cannot however be ruled out in which the profiled element 4 is fixed within the vacuum cabin 2 in a different working position, e.g. vertical or slanting.

Usefully, the vacuum cabin 2 comprises at least a resting plane 12 on which is placeable a target material to be pulverized, arranged substantially horizontal with respect to the ground and at the profiled element 4.

More in detail, the resting plane 12 is associated with the bottom wall 6a by means of appropriate supporting bars adapted to keep the resting plane itself in fixed position within the vacuum cabin 2.

In the preferred embodiment shown in the figures, the vacuum machinery 1 comprises at least one dispensing device 13 for dispensing at least one substantially inert aeriform substance A1 within the vacuum cabin 2.

The aeriform substance A1 is selected from the group comprising: argon, neon, crypton and xenon.

Preferably, the aeriform substance A1 employed in the present embodiment is argon.

Alternative embodiments cannot however be ruled out in which the dispensing device 13 is adapted to the dispensing of a substantially reactive aeriform substance, e.g. oxygen.

The simultaneous dispensing of the inert aeriform substance A1 and of the reactive aeriform substance within the vacuum cabin 2 allows the reaction of the reactive aeriform substance itself with a target to be sputtered and, at the same time, the bombardment of the target to be sputtered itself with the aeriform substance A1 in order to obtain a layer of composite material for the coating of a surface to be coated.

In other words, the introduction of the aeriform substance A1 and of the reactive aeriform substance within the vacuum cabin allows obtaining a chemical-physical vapor deposition of one or more targets on the surface to be coated.

In particular, the dispensing device 13 is arranged externally to the vacuum cabin 2 and is connected to the vacuum cabin itself by means of a duct 14, e.g. a tubular element, adapted to convey the aeriform substance A1 within the vacuum cabin 2.

In the preferred embodiment shown in the figures, the device for physical vapor deposition 3 employed for the coating of the profiled elements 4 is a device for cathode sputtering.

More in detail, the selected device for cathode sputtering 3 is a pulsed dc magnetron i.e., a device which, by using pulsed direct current power supply in combination to a magnetic field, allows to create a current of ions that bombards the target and avoids the formation of a non-conductive oxide layer on the target itself when the voltage is substantially zero.

The main advantage of the pulsed dc magnetron is to increase the rate of ionization, and therefore the rate of erosion of the target, thus speeding up the sputtering operations of the target itself.

The pulsed dc magnetron allows the deposition of both electrically conductive materials, e.g. aluminum, and semiconductor materials, the electrical conductivity of which is variable depending on the operating temperature. Furthermore, the pulsed dc magnetron is particularly useful in the case of reactive depositions that occur by means of the simultaneous dispensing of the inert aeriform substance A1 and of the reactive aeriform substance.

Alternative embodiments cannot however be ruled out in which the selected device for cathode sputtering 3 is a radio frequency magnetron, i.e. a passive device adapted to generate a magnetostatic field for the ionization and the deviation of the trajectory of particles and ions with electrical charge, subjected to the Lorentz force, towards the target to be coated with respect to the direction provided by the field lines.

Unlike the pulsed dc magnetron usable for the deposition of electrically conductive and semiconductor materials, the radio frequency magnetron employed for the sputtering deposition process is versatile and usable for the deposition of electrically conductive materials, e.g. aluminum, of semiconductor materials, e.g. insulating materials doped with electrically conductive materials, and of electrically insulating materials, such as ceramic or glass.

More in detail, the type of magnetostatic field generated by the radio frequency magnetron is applicable, with good performance in terms of operational efficiency, both to the electrically conductive materials and to the electrically insulating materials.

Similarly to the pulsed dc magnetron, also the radio frequency magnetron is particularly useful in the case of reactive depositions.

Alternative embodiments cannot however be ruled out in which the selected device for cathode sputtering 3 is a dc magnetron, i.e. a device adapted to maintain a high direct current between the target one wishes to sputter, made of an electrically conductive material, and the material one wishes to coat, and to the introduction of a magnetic field which lays over the discharge in the proximity of the surface of the target.

Alternative embodiments cannot also be ruled out in which the vacuum cabin 2 comprises a plurality of devices for cathode sputtering 3 which are different to each other, including radio frequency magnetrons adapted to the deposition of electrically conductive, semiconductor and insulating materials, pulsed dc magnetrons adapted to the deposition of electrically conductive materials and semiconductor materials, and dc magnetrons.

Advantageously, the combination of pulsed dc magnetrons and radio frequency magnetrons allows speeding up the steps of sputtering deposition in the event of the deposition being required of both electrically conducting or semiconductor materials and electrically insulating materials.

The procedure comprises a first step of introduction of a coloring material C1 within the vacuum cabin 2 and, particularly, on top of the resting plate 12.

The coloring material C1 performs the function of target material for the device for cathode sputtering 3 for the coating of the profiled element 4.

Preferably, the coloring material C1 is selected from the group comprising: electrically conductive materials, e.g. aluminum, semiconductor materials and electrically insulating materials, e.g. ceramic, having therefore a different colour depending on the type of selected material.

More in detail, the coloring material C1 has a solid form, e.g. of the type of a cube or a sheet.

The procedure also comprises a first step of physical vapor deposition for the coating of the profiled element 4 with the coloring material C1 to obtain one coloring layer 15 adapted to determine aesthetic characteristics of various type, depending on the coloring material C1 used, and particularly outstanding and pleasant to the eye.

The coloring layer 15 covers at least partly the surface of the profiled element 4. More in detail, the first step of physical vapor deposition comprises one step of sputtering deposition for the coating of the profiled element 4.

In other words, the step of sputtering deposition is commonly known as "sputtering", by means of which the deposition takes place of a target material eroded by ionized material particles by means of, e.g., a device for cathode sputtering 3.

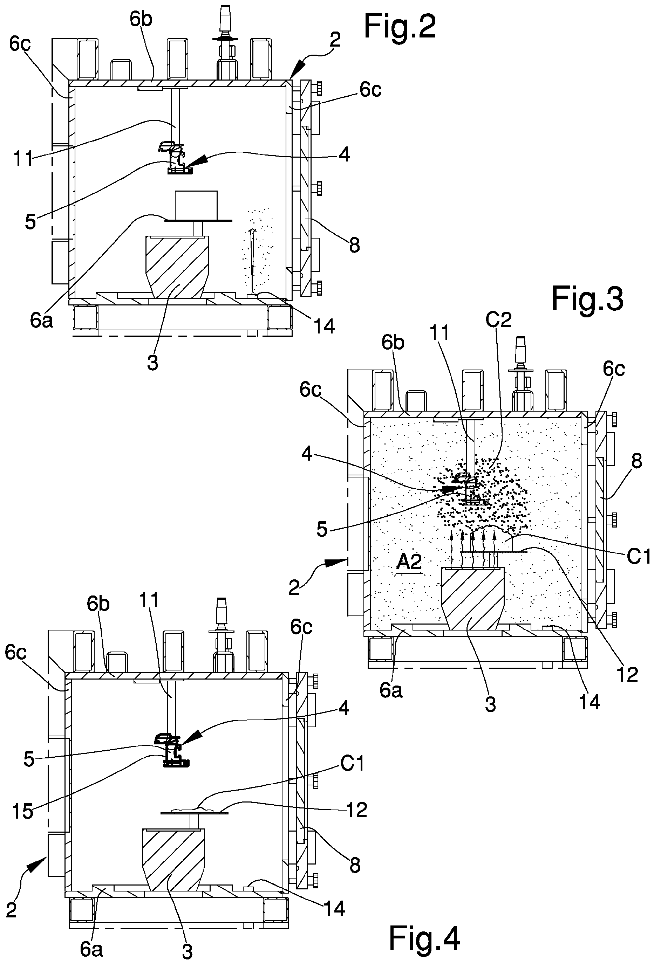

Usefully, the first step of sputtering deposition comprises an ionization step of the aeriform substance A1, shown in Figure 2, conveyed within the vacuum cabin 2, by means of the device for cathode sputtering 3 to obtain an ionized aeriform substance A2 which, in the present context, is ionized argon.

The first step of physical vapor deposition comprises:
- a first step of movement of the ionized aeriform substance A2, shown in Figure 3, by means of the device for cathode sputtering 3 in the proximity of the coloring material C1 to obtain a pulverized coloring material C2. More particularly, the ionized aeriform substance A2 is moved in the proximity of the coloring material C1 arranged on top of the resting plane 12 by means of the particular magnetostatic field generated by the device for cathode sputtering 3. The ionized particles of the ionized aeriform substance A2 erode the coloring material C1 until obtaining the pulverized coloring material C2 that is dispersed within the vacuum cabin 2. Preferably, the coloring material C1 is eroded until obtaining an amount of pulverized coloring material C2 such as to obtain the coloring layer 15;
- a first step of fixing of the pulverized coloring material C2 on the surface of the profiled element 4, shown in Figure 4, by means of the device for cathode sputtering 3 to obtain the coloring layer 15. More in detail, the pulverized coloring material C2 is conveyed, again by means of the device for cathode sputtering 3, to the profiled element 4 until its complete deposition, and then fixing, onto the entire surface of the profiled element itself.

At the end of the first step of physical vapor deposition, therefore, the coloring layer 15 covers entirely the surface of the profiled element 4.

According to the invention, the procedure comprises a second step of introduction of a protective material PI within the vacuum cabin 2 and, in particular, on top of the resting plane 12.

The protective material PI performs the function of target material for the device for cathode sputtering 3 for the coating of the profiled element 4. Preferably, the protective material PI is at least partly transparent and allows light passing through it.

Preferably, the protective material PI is selected from electrically insulating materials and semiconductor materials.

In particular, the protective material PI is glass, but alternative embodiments cannot be ruled out in which the protective material PI employed for the coating of the profiled element 4 is an at least partly transparent material different from glass, e.g., Plexiglas.

More in detail, the protective material PI has a solid form, e.g. of the type of a cube or a sheet.

The procedure comprises a second step of physical vapor deposition for the coating of the profiled element 4 with the protective material PI to obtain a protective layer 16 adapted to cover at least partly the coloring layer 15 previously fixed onto the surface of the profiled element 4 during the first step of physical vapor deposition.

Similarly to the first step of physical vapor deposition, also the second step of physical vapor deposition usefully comprises the step of sputtering deposition for the coating of the profiled element 4.

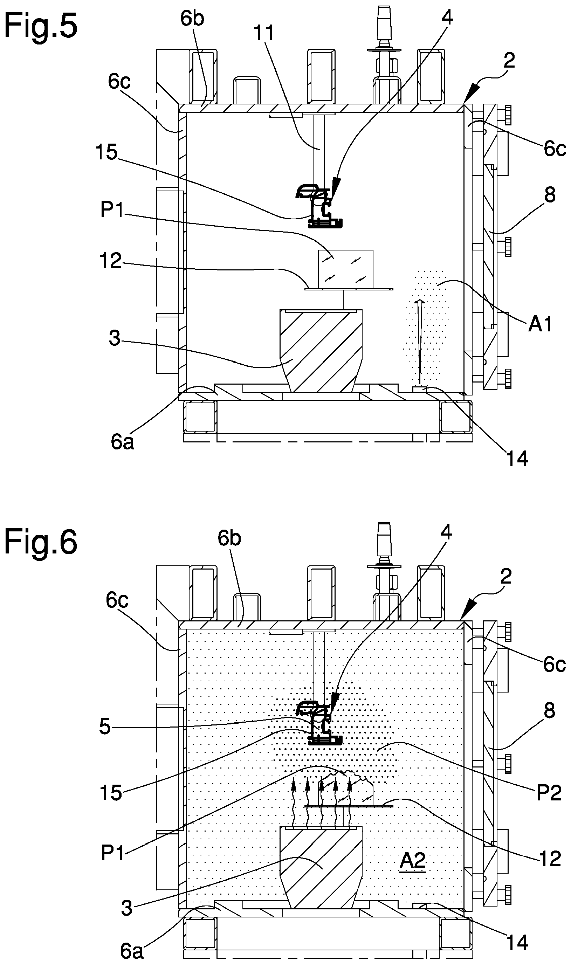

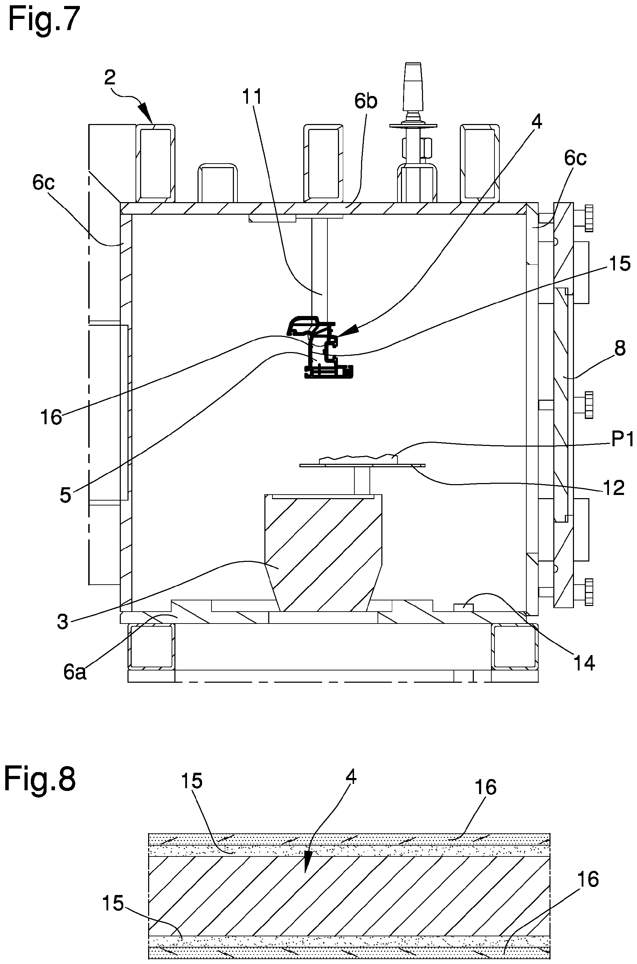

The second step of physical vapor deposition comprises:
- a second step of movement of the ionized aeriform substance A2, shown in Figure 6, by means of the device for cathode sputtering 3, in the proximity of the protective material PI to obtain a pulverized protective material P2. More particularly, the ionized aeriform substance A2 is moved in the proximity of the protective material PI arranged on top of the resting plane 12 by means of the particular magneto static field generated by the device for cathode sputtering 3. The ionized particles of the ionized aeriform substance A2 erode the protective material PI until obtaining the pulverized protective material P2 that is dispersed within the vacuum cabin 2. Preferably, the protective material PI is eroded until obtaining an amount of pulverized protective material P2 such as to obtain the coloring layer 15;
- a second step of fixing of the pulverized protective material P2 on top of the protective layer 16, shown in Figure 7, by means of the device for cathode sputtering 3 to obtain the protective layer 16 of the profiled element 4 until its complete deposition, and then fixing, onto the entire surface of the profiled element itself.

At the end of the second step of physical vapor deposition, therefore, the protective layer 16 covers entirely the surface of the profiled element 4 and then the coloring layer 15 protecting it and making it resistant to wear and the action of corrosive agents of various nature.

It has in practice been found that the described invention achieves the intended objects and in particular the fact is underlined that the profiled elements obtained by means of the previously described procedure have a particular aesthetic appearance depending on the coloring material used.

The layer of protective material covering entirely the surface of the profiled element allows maintaining unaltered the aesthetic characteristics of the profiled element thus obtained, since it prevents the pulverized coloring material fixed onto the surface of the profiled element itself from detaching or losing its aesthetic characteristics which were present in the realization step.

At the same time, by employing a transparent protective material, such as glass, the aesthetic perception of the coloring material deposited on the surface of the profiled element is unchanged.

The particular expedient to provide for a sputtering deposition procedure, in fact, allows to manufacture frames of doors and windows which, albeit made of plastic material, have a valuable aesthetic appearance, such as e.g. a metallic effect, which is impossible to achieve with the plastics used for the manufacture of PVC profiled elements.

It is apparent, furthermore, that by means of the described procedure it is possible to carry out, within a single vacuum cabin, the coating of the profiled elements made of plastic material both with a coloring material of metallic or ceramic type, by means of which is obtained the metallic aesthetic effect, and with a transparent protective material that prevents degradation of the aesthetic characteristics of the obtained coloring effect.

## Claims

1. Procedure for the coating of profiled elements made of plastic material for door and window frames, comprising:
- at least one step of supply of at least a vacuum machinery (1) comprising at least a vacuum cabin (2) having at least a device for physical vapor deposition (3) suitable for the coating of at least one profiled element (4) made of plastic material to be coated for the manufacture of door and window frames;
- at least one step of insertion of said profiled element (4) within said vacuum cabin (2);
- at least a first step of introduction of at least a coloring material (CI) within said vacuum cabin (2);
- at least a first step of physical vapor deposition for the coating of said profiled element (4) with said coloring material (C1) to obtain at least one coloring layer (15), said coloring layer (15) covering at least partly the surface of said profiled element (4);
**characterized in that** it comprises:
- at least a second step of introduction of at least a protective material (P1) within said vacuum cabin (2), said protective material (P1) being at least partly transparent;
- at least a second step of physical vapor deposition for the coating of said profiled element (4) with said protective material (P1) to obtain at least one protective layer (16), said protective layer (16) covering at least partly said coloring layer (15).

2. Procedure according to claim 1, **characterized in that** said coloring material (C1) is selected from the group comprising: electrically conductive materials, electrically insulating materials and semiconductor materials.

3. Procedure according to one or more of the preceding claims, **characterized in that** said protective material (P1) is selected from electrically insulating materials and semiconductor materials.

4. Procedure according to one or more of the preceding claims, **characterized in that** said device for physical vapor deposition (3) is a device for cathode sputtering.

5. Procedure according to one or more of the preceding claims, **characterized in that** said vacuum machinery (1) comprises at least one dispensing device (13) for dispensing at least one aeriform substance (A1) substantially inert within said vacuum cabin (2).

6. Procedure according to one or more of the preceding claims, **characterized in that** said aeriform substance (A1) is selected from the group comprising: argon, neon, crypton and xenon.

7. Procedure according to one or more of the preceding claims, **characterized in that** at least one of said first and said second step of physical vapor deposition comprises at least one step of cathode sputtering deposition for the coating of said profiled element (4).

8. Procedure according to one or more of the preceding claims, **characterized in that** said step of cathode sputtering deposition comprises an ionization step of said aeriform substance (A1) by means of said device for cathode sputtering (3) to obtain at least one ionized aeriform substance (A2).

9. Procedure according to one or more of the preceding claims, **characterized in that** said first step of physical vapor deposition comprises:
- a first step of movement of said ionized aeriform substance (A2), by means of said device for cathode sputtering (3), in the proximity of said coloring material (C1) to obtain at least one pulverized coloring material (C2);
- a first step of fixing of said pulverized coloring material (C2) on the surface of said profiled element (4) by means of said device for cathode sputtering (3) to obtain said coloring layer (15).

10. Procedure according to one or more of the preceding claims, **characterized in that** said second step of physical vapor deposition comprises:
- a second step of movement of said ionized aeriform substance (A2), by means of said device for cathode sputtering (3), in the proximity of said protective material (P1) to obtain at least one pulverized protective material (P2);
- a second step of fixing of said pulverized protective material (P2) on top of said protective layer (16), by means of said device for cathode sputtering (3) to obtain said protective layer (16) of said profiled element (4).

## Patentansprüche

1. Verfahren zur Beschichtung von Kunststoff-Profilelementen für Tür-und Fensterrahmen, umfassend:
- mindestens einen Versorgungsschritt mindestens einer Vakuum-Maschine (1), welche mindestens eine Vakuum-Kabine (2) mit mindestens einer Vorrichtung zur physikalischen Dampfabscheidung (3), ausgelegt für die Beschichtung mindestens eines Profilelements (4) aus Kunststoff, welcher für die Herstellung von Tür-und Fensterrahmen zu beschichten ist, umfasst;
- mindestens einen Schritt des Einsetzens des Profilelements (4) in die Vakuum-Kabine (2);
- mindestens einen ersten Einführungsschritt mindestens eines Färbe-Materials (C1) in die Vakuum-Kabine (2);
- mindestens einen ersten Schritt der physikalischen Dampfabscheidung zur Beschichtung des Profilelements (4) mit dem Färbe-Material (Cl), um mindestens eine Farbschicht (15) zu erhalten, wobei die Farbschicht (15) zumindest teilweise die Oberfläche des Profilelements (4) bedeckt;
**dadurch gekennzeichnet, dass** es umfasst:
- mindestens einen zweiten Einführungsschritt mindestens eines Schutzmaterials (P1) in die Vakuum-Kabine (2), wobei das Schutzmaterial (P1) zumindest teilweise transparent ist;
- mindestens einen zweiten Schritt der physikalischen Dampfabscheidung zur Beschichtung des Profilelements (4) mit dem Schutzmaterial (P1), um mindestens eine Schutzschicht (16) zu erhalten, wobei die Schutzschicht (16) zumindest teilweise die Farbschicht (15) überdeckt.

2. Verfahren nach Anspruch 1, **dadurch gekennzeichnet, dass** das Färbe-Material (C1) aus elektrisch leitendem Material, elektrisch isolierendem Material oder Halbleiter-Material besteht.

3. Verfahren nach mindestens einem der vorherigen Ansprüche, **dadurch gekennzeichnet, dass** das Schutzmaterial (P1) aus elektrisch isolierendem Material oder Halbleiter-Material besteht.

4. Verfahren nach mindestens einem der vorherigen Ansprüche, **dadurch gekennzeichnet, dass** die Vorrichtung zur physikalischen Dampfabscheidung (3) eine Vorrichtung zur Kathodenzerstäubung ist.

5. Verfahren nach mindestens einem der vorherigen Ansprüche, **dadurch gekennzeichnet, dass** die Vakuum-Maschine (1) mindestens eine Ausgabe-Vorrichtung (13) zur Ausgabe mindestens einer gasförmigen Substanz (A1), welche innerhalb der Vakuum-Kabine (2) im Wesentlichen inert ist, umfasst.

6. Verfahren nach mindestens einem der vorherigen Ansprüche, **dadurch gekennzeichnet, dass** die gasförmige Substanz (A1) aus Argon, Neon, Krypton oder Xenon besteht.

7. Verfahren nach mindestens einem der vorherigen Ansprüche, **dadurch gekennzeichnet, dass** mindestens einer des ersten und zweiten Schrittes der physikalischen Dampfabscheidung mindestens einen Schritt der Kathodenzerstäubungs-Abscheidung zur Beschichtung des Profilelements (4) umfasst.

8. Verfahren nach mindestens einem der vorherigen Ansprüche, **dadurch gekennzeichnet, dass** der Schritt der Kathodenzerstäubungs-Abscheidung einen Ionisierungs-Schritt der gasförmigen Substanz (A1) mittels der Vorrichtung zur Kathodenzerstäubung (3) zum Gewinnen mindestens einer ionisierten gasförmigen Substanz (A2) umfasst.

9. Verfahren nach mindestens einem der vorherigen Ansprüche, **dadurch gekennzeichnet, dass** der erste Schritt der physikalischen Dampfabscheidung umfasst:
- einen ersten Bewegungs-Schritt der ionisierten gasförmigen Substanz (A2) mittels der Vorrichtung zur Kathodenzerstäubung (3) in der Nähe des Färbe-Materials (Cl), um mindestens ein pulverisiertes Färbe-Material (C2) zu erhalten;
- einen ersten Befestigungs-Schritt des pulverisierten Färbe-Materials (C2) auf der Oberfläche des Profilelements (4) durch die Vorrichtung zur Kathodenzerstäubung (3), um die Farbschicht (15) zu erhalten.

10. Verfahren nach mindestens einem der vorherigen Ansprüche, **dadurch gekennzeichnet, dass** der zweite Schritt der physikalischen Dampfabscheidung umfasst:
- einen zweiten Bewegungsschritt der ionisierten gasförmigen Substanz (A2) mittels der Vorrichtung zur Kathodenzerstäubung (3) in der Nähe des Schutzmaterials (P1), um mindestens ein pulverisiertes Schutzmaterial (P2) zu erhalten;
- einen zweiten Schritt zur Befestigung des pulverisierten Schutzmaterials (P2) auf der Schutzschicht (16) mittels der Vorrichtung zur Kathodenzerstäubung (3), um die Schutzschicht (16) des Profilelements (4) zu erhalten.

## Revendications

1. Procédé pour le revêtement d'éléments profilés constitués de matière plastique pour cadres de porte et de fenêtre, comprenant :
- au moins une étape de fourniture d'au moins une machine à vide (1) comprenant au moins une cabine à vide (2) ayant au moins un dispositif pour dépôt physique en phase vapeur (3) approprié pour le revêtement d'au moins un élément profilé (4) constitué de matière plastique devant être revêtu pour la fabrication de cadres de porte et de fenêtre ;
- au moins une étape d'insertion dudit élément profilé (4) à l'intérieur de ladite cabine à vide (2) ;
- au moins une première étape d'introduction d'au moins un matériau colorant (C1) à l'intérieur de ladite cabine à vide (2) ;
- au moins une première étape de dépôt physique en phase vapeur pour le revêtement dudit élément profilé (4) avec ledit matériau colorant (C1) pour obtenir au moins une couche colorante (15), ladite couche colorante (15) recouvrant au moins partiellement la surface dudit élément profilé (4) ;
**caractérisé en ce qu'**il comprend :
- au moins une seconde étape d'introduction d'au moins un matériau protecteur (P1) à l'intérieur de ladite cabine à vide (2), ledit matériau protecteur (P1) étant au moins partiellement transparent ;
- au moins une seconde étape de dépôt physique en phase vapeur pour le revêtement dudit élément profilé (4) avec ledit matériau protecteur (P1) pour obtenir au moins une couche protectrice (16), ladite couche protectrice (16) recouvrant au moins partiellement ladite couche colorante (15).

2. Procédé selon la revendication 1, **caractérisé en ce que** ledit matériau colorant (C1) est sélectionné parmi le groupe comprenant : des matériaux électriquement conducteurs, des matériaux électriquement isolants et des matériaux semi-conducteurs.

3. Procédé selon l'une ou plusieurs des revendications précédentes, **caractérisé en ce que** ledit matériau protecteur (P1) est sélectionné parmi des matériaux électriquement isolants et des matériaux semi-conducteurs.

4. Procédé selon l'une ou plusieurs des revendications précédentes, **caractérisé en ce que** ledit dispositif pour dépôt physique en phase vapeur (3) est un dispositif pour pulvérisation cathodique.

5. Procédé selon l'une ou plusieurs des revendications précédentes, **caractérisé en ce que** ladite machine à vide (1) comprend au moins un dispositif de distribution (13) pour distribuer au moins une substance aériforme (A1) sensiblement inerte à l'intérieur de ladite cabine à vide (2).

6. Procédé selon l'une ou plusieurs des revendications précédentes, **caractérisé en ce que** ladite substance aériforme (A1) est sélectionnée parmi le groupe comprenant : l'argon, le néon, le krypton et le xénon.

7. Procédé selon l'une ou plusieurs des revendications précédentes, **caractérisé en ce qu'**au moins une parmi ladite première et ladite seconde étape de dépôt physique en phase vapeur comprend au moins une étape de dépôt par pulvérisation cathodique pour le revêtement dudit élément profilé (4).

8. Procédé selon l'une ou plusieurs des revendications précédentes, **caractérisé en ce que** ladite étape de dépôt par pulvérisation cathodique comprend une étape d'ionisation de ladite substance aériforme (A1) au moyen dudit dispositif pour pulvérisation cathodique (3) pour obtenir au moins une substance aériforme ionisée (A2).

9. Procédé selon l'une ou plusieurs des revendications précédentes, **caractérisé en ce que** ladite première étape de dépôt physique en phase vapeur comprend :
- une première étape de déplacement de ladite substance aériforme ionisée (A2), au moyen dudit dispositif pour pulvérisation cathodique (3), à proximité dudit matériau colorant (C1) pour obtenir au moins un matériau colorant pulvérisé (C2) ;
- une première étape de fixation dudit matériau colorant pulvérisé (C2) sur la surface dudit élément profilé (4) au moyen dudit dispositif pour pulvérisation cathodique (3) pour obtenir ladite couche colorante (15).

10. Procédé selon l'une ou plusieurs des revendications précédentes, **caractérisé en ce que** ladite seconde étape de dépôt physique en phase vapeur comprend :
- une seconde étape de déplacement de ladite substance aériforme ionisée (A2), au moyen dudit dispositif pour pulvérisation cathodique (3), à proximité dudit matériau protecteur (P1) pour obtenir au moins un matériau protecteur pulvérisé (P2) ;
- une seconde étape de fixation dudit matériau protecteur pulvérisé (P2) sur le dessus de ladite couche protectrice (16), au moyen dudit dispositif pour pulvérisation cathodique (3) pour obtenir ladite couche protectrice (16) dudit élément profilé (4).
